(19) Europäisches Patentamt
European Patent Office
Office européen des brevets

(11) **EP 2 637 141 A2**

(12) **EUROPEAN PATENT APPLICATION**

(43) Date of publication:
**11.09.2013 Bulletin 2013/37**

(51) Int Cl.:
**G06T 7/00** (2006.01)　　　**G06T 7/20** (2006.01)

(21) Application number: **13157886.6**

(22) Date of filing: **05.03.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.03.2012 KR 20120023076**

(71) Applicant: **Samsung Electronics Co., Ltd Gyeonggi-do 443-742 (KR)**

(72) Inventors:
• **Hyung, Seung Yong**
　**Gyeonggi-do (KR)**
• **Kim, Dong Soo**
　**Gyeonggi-do (KR)**

• **Roh, Kyung Shik**
　**Gyeonggi-do (KR)**
• **Shim, Young Bo**
　**Seoul (KR)**
• **Yoon, Suk June**
　**Seoul (KR)**
• **Hwang, Won Jun**
　**Seoul (KR)**
• **Hwang, Hyo Seok**
　**Seoul (KR)**

(74) Representative: **Taor, Simon Edward William Venner Shipley LLP 200 Aldersgate London EC1A 4HD (GB)**

(54) **Method and Apparatus for Pose Recognition**

(57) An apparatus and a method for pose recognition, the method for pose recognition including generating a model of a human body in a virtual space, predicting a next pose of the model of the human body based on a state vector having an angle and an angular velocity of each part of the human body as a state variable, predicting a depth image about the predicted pose, and recognizing a pose of a human in a depth image captured in practice, based on a similarity between the predicted depth image and the depth image captured in practice, wherein the next pose is predicted based on the state vector having an angular velocity as a state variable, thereby reducing the number of pose samples to be generated and improving the pose recognition speed.

FIG. 6

**Description**

Embodiments of the present disclosure relate to a method and an apparatus for pose recognition, and more particularly, to a method and an apparatus for pose recognition capable of improving the recognition speed thereof.

In recent years, as a non-contact sensor, such as a depth camera or an accelerometer, has been developed, an interface between a human and machine equipment is converted from a contact method to a non-contact method.

The depth camera radiates a laser or an Infrared Ray (IR) at an object, and based on the time taken for the radiated laser or IR to return after being reflected by the object, that is, based on Time of Flight (TOF), calculates the distance between the camera and the object, that is, depth information of the object. By use of the depth camera, a three-dimensional depth image including depth information for each pixel is obtained.

If the three-dimensional depth image obtained as the above is used, pose information of a human may be measured to a more precise extent when compared to a case only using two-dimensional images.

One example of a method of obtaining pose information in the above manner is a probabilistic pose information obtaining method. The probabilistic pose information obtaining method is achieved as follows. First, a model of a human body is generated by representing each body part (the head, the torso, the left upper arm, the left lower arm, the right upper arm, the right lower arm, the left thigh, the left calf, the right thigh, and the right calf) in the form of a cylinder. Thereafter, a number of pose samples are generated by changing an angle, that is, a joint angle, between the cylinders from an initial posture of the model of the human body. Subsequently, a depth image obtained through a depth camera is compared with projection images obtained by projecting the respective pose samples to the human body such that a projection image having the most similar pose to the obtained depth image is selected. Finally, pose information of the selected projection image is obtained.

However, when using the probabilistic pose information obtaining method, there is a need for generating projections images about a plurality of candidate postures, resulting in the increase of computation and the time required to obtain the pose information.

Therefore, it is an aspect of the present disclosure to provide a method and an apparatus for pose recognition, capable of reducing the time taken for pose recognition.

Additional aspects of the disclosure will be set forth in part in the description which follows and, in part, will be apparent from the description, or may be learned by practice of the disclosure.

In accordance with one aspect of the present disclosure, a method of recognizing a pose is as follows. A model of a human body may be generated in a virtual space. A next pose of the model of the human body may be predicted based on a state vector having an angle and an angular velocity of each part of the human body as a state variable. A depth image about the predicted pose may be predicted. A pose of a human in a depth image captured in practice may be recognized, based on a similarity between the predicted depth image and the depth image captured in practice.

The predicting of the next pose of the model of the human body may be achieved by performing the following. An average of the state variable may be calculated. A covariance of the state variable may be calculated based on the average of the state variable. A random number may be generated based on the covariance of the state variable. The next pose may be predicted by use of a variation that is generated based on the random number.

The predicting of the depth image about the predicted pose may be achieved by performing the following. If the model of the human body takes the predicted pose, a virtual image predicted about a silhouette of the model of the human body that is to be represented in an image may be generated. A size of the virtual image may be normalized to a predetermined size. A depth image including depth information for each point existing at an inside of the silhouette in the normalized virtual image may be predicted.

The normalizing of the size of the virtual image to the predetermined size may be achieved by performing the following. The size of the virtual image may be reduced at a predetermined reduction rate. The reduction rate may be a value of a size of a human, which is acquired in the virtual image, divided by a desired reduction size of the human.

The recognizing of the pose based on the similarity may be achieved by performing the following. A pose, which has a highest similarity among similarities based on poses having been predicted about the model of the human body by a present moment of time, may be selected as a final pose. The pose of the human in the depth image captured in practice may be recognized based on a joint angle of the final pose.

The method may be achieved by further performing the following. A similarity between the predicted depth image and the depth image captured in practice may be calculated. If the calculated similarity is larger than a similarity previously calculated, the predicted pose may be set as a reference pose, and if the calculated similarity is smaller than a similarity previously calculated, a previous pose may be set as a reference pose.

The next pose may be predicted based on the reference pose.

The predicting of the next pose based on the reference pose may be achieved by performing the following. If the poses having been predicted about the human body by the present moment of time do not conform a normal distribution with respect to the pose of the human in the depth image captured in practice, a next pose may be predicted based on the reference pose.

In accordance with another aspect of the present disclosure, an apparatus for recognizing a pose includes a modeling unit, a pose sample generating unit, an image predicting unit, and a pose recognizing unit. The modeling unit may be configured to generate a model of a human body in a virtual space. The pose sample generating unit may be configured to predict a next pose of the model of the human body based on a state vector having an angle and an angular velocity of each part of the human body as a state variable. The image predicting unit may be configured to predict a depth image about the predicted pose. The pose recognizing unit may be configured to recognize a pose of a human in a depth image captured in practice, based on a similarity between the predicted depth image and the depth image captured in practice.

The pose sample generating unit may calculate a covariance of the state variable based on an average of the state variable, and predict the next pose by using a random number, which is generated based on the covariance of the state variable, as a variation.

The image predicting unit may include a virtual image generating unit, a normalization unit, and a depth image generating unit. The virtual image generating unit may be configured to generate, if the model of the human body takes the predicted pose, a virtual image predicted about a silhouette of the model of the human body that is to be represented in an image. The normalization unit may be configured to normalize a size of the virtual image to a predetermined size. The depth image generating unit may be configured to predict a depth image comprising depth information for each point existing at an inside the silhouette in the normalized virtual image.

The normalization unit may reduce the size of the virtual image at a predetermined reduction rate. The reduction rate may be a value of a size of a human, which is acquired in the virtual image, divided by a desired reduction size of the human.

The pose recognizing unit may select a pose, which has a highest similarity among similarities based on poses having been predicted about the human body by a present moment of time, as a final pose, and recognize the pose of the human in the depth image captured in practice, based on a joint angle of the final pose.

The pose recognizing unit may include a similarity calculating unit and reference pose setting unit. The similarity calculating unit may be configured to calculate a similarity between the predicted depth image and the depth image captured in practice. The reference pose setting unit, if the calculated similarity is larger than a similarity previously calculated, may be configured to set the predicted pose as a reference pose, and if the calculated similarity is smaller than a similarity previously calculated, may be configured to set a previous pose as a reference pose.

The pose sample generating, if the poses having been predicted about the human body by the present moment of time do not conform to a normal distribution with respect to the pose of the human in the depth image captured in practice, may be configured to predict a next pose based on the reference pose.

According to an aspect of the invention, there is provided a method of recognizing a pose, the method comprising: generating a model of a human body in a virtual space using at least one processor; predicting a next pose of the model of the human body based on a state vector having an angle and an angular velocity of each part of the human body as a state variable; predicting a depth image about the predicted pose; and recognizing a pose of a human in a depth image captured in practice, based on a similarity between the predicted depth image and the depth image captured in practice.

In some embodiments, the predicting of the next pose of the model of the human body comprises: calculating an average of the state variable; calculating a covariance of the state variable based on the average of the state variable; generating a random number based on the covariance of the state variable; and predicting the next pose by use of a variation that is generated based on the random number.

In some embodiments, the predicting of the depth image about the predicted pose comprises: generating, if the model of the human body takes the predicted pose, a virtual image predicted about a silhouette of the model of the human body that is to be represented in an image; normalizing a size of the virtual image to a predetermined size; and predicting a depth image comprising depth information for each point existing at an inside the silhouette in the normalized virtual image.

In some embodiments, the normalizing of the size of the virtual image to the predetermined size comprises: reducing the size of the virtual image at a predetermined reduction rate, wherein the reduction rate is a value of a size of a human, which is acquired in the virtual image, divided by a desired reduction size of the human.

In some embodiments, the recognizing of the pose based on the similarity comprises: selecting a pose, which has a highest similarity among similarities based on poses having been predicted about the model of the human body by a present moment of time, as a final pose; and recognizing the pose of the human in the depth image captured in practice, based on a joint angle of the final pose.

In some embodiments, the method further comprising: calculating a similarity between the predicted depth image and the depth image captured in practice; setting, if the calculated similarity is larger than a similarity previously calculated, the predicted pose as a reference pose, and if the calculated similarity is smaller than a similarity previously calculated, setting a previous pose as a reference pose; and predicting the next pose based on the reference pose.

In some embodiments, the predicting of the next pose based on the reference pose comprises: predicting, if the poses having been predicted about the human body by the present moment of time do not conform a normal distribution with respect to the pose of the human in the depth image captured in practice, a next pose based on the reference pose.

According to an aspect of the invention, there is provided an apparatus for recognizing a pose, the apparatus comprising: a modeling unit configured to generate a model of a human body in a virtual space; a pose sample generating unit configured to predict a next pose of the model of the human body based on a state vector having an angle and an angular velocity of each part of the human body as a state variable; an image predicting unit configured to predict a depth image about the predicted pose; and a pose recognizing unit configured to recognize a pose of a human in a depth image captured in practice, based on a similarity between the predicted depth image and the depth image captured in practice.

In some embodiments, the pose sample generating unit calculates a covariance of the state variable based on an average of the state variable, and predicts the next pose by using a random number, which is generated based on the covariance of the state variable, as a variation.

In some embodiments, the image predicting unit comprises: a virtual image generating unit configured to generate, if the model of the human body takes the predicted pose, a virtual image predicted about a silhouette of the model of the human body that is to be represented in an image; a normalization unit configured to normalize a size of the virtual image to a predetermined size; and a depth image generating unit configured to predict a depth image comprising depth information for each point existing at an inside the silhouette in the normalized virtual image.

In some embodiments, the normalization unit reduces the size of the virtual image at a predetermined reduction rate, and wherein the reduction rate is a value of a size of a human, which is acquired in the virtual image, divided by a desired reduction size of the human.

In some embodiments, the pose recognizing unit selects a pose, which has a highest similarity among similarities based on poses having been predicted about the model of the human body by a present moment of time, as a final pose, and recognizes the pose of the human in the depth image captured in practice, based on a joint angle of the final pose.

In some embodiments, the pose recognizing unit comprises: a similarity calculating unit configured to calculate a similarity between the predicted depth image and the depth image captured in practice; and a reference pose setting unit, if the calculated similarity is larger than a similarity previously calculated, configured to set the predicted pose as a reference pose, and if the calculated similarity is smaller than a similarity previously calculated, configured to set a previous pose as a reference pose.

In some embodiments, the pose sample generating, if the poses having been predicted about the human body by the present moment of time do not conform a normal distribution with respect to the pose of the human in the depth image captured in practice, is configured to predict a next pose based on the reference pose.

According to an aspect of the invention, there is provided a pose recognition apparatus comprising: an image acquisition unit to capture a depth image of an object; a modeling unit configured to generate a model of the object in a virtual space; a pose sample generating unit to predict a next pose of the model based on a state vector having an angle and an angular velocity of each part of the model as a state variable; an image predicting unit to predict a depth image about the predicted pose; and a pose recognizing unit to recognize a pose of the object in the depth image captured by the image acquisition unit, based on the similarity between the depth image generated by the depth image generating unit and the depth image captured by the image acquisition unit.

In some embodiments, the pose sample generating unit calculates a covariance of the state variable based on an average of the state variable, and predicts the next pose by using a random number, which is generated based on the covariance of the state variable, as a variation.

In some embodiments, the image predicting unit comprises: a virtual image generating unit configured to generate, if the model of the object takes the predicted pose, a virtual image predicted about a silhouette of the model of the object that is to be represented in an image; a normalization unit configured to normalize a size of the virtual image to a predetermined size; and a depth image generating unit configured to predict a depth image comprising depth information for each point existing at an inside the silhouette in the normalized virtual image.

In some embodiments, the normalization unit reduces the size of the virtual image at a predetermined reduction rate.

In some embodiments, the pose recognizing unit comprises: a similarity calculating unit to calculate a similarity between the predicted depth image and the captured depth image; and a reference pose setting unit to, if the calculated similarity is larger than a similarity previously calculated, set the predicted pose as a reference pose, and if the calculated similarity is smaller than a similarity previously calculated, set a previous pose as a reference pose.

According to an aspect of the invention, there is provided a method of recognizing a pose as set out in claim 1. Preferred features of this aspect are set out in claims 2 to 8.

According to an aspect of the invention, there is provided a pose recognition apparatus as set out in claim 9. Preferred features of this aspect are set out in claims 10 to 15.

As described above, according to the embodiments of the present disclosure, the next pose is predicted based on the state vector including the angle and the angular velocity of each part of the model of the human body generated in the virtual space as the state variables, and thus the number of pose samples being generated is reduced and the pose recognition speed is improved.

Since the depth image is generated after the size of the virtual image with respect to the predicted pose is normalized, the amount of computation is reduced when compared to generating the depth image without normalizing the virtual image, and the pose recognition speed is improved.

These and/or other aspects of the disclosure will become apparent and more readily appreciated from the following description of the embodiments, taken in conjunction with the accompanying drawings of which:

FIG. 1 is a view illustrating the configuration of a pose recognition apparatus in accordance with an embodiment of the present disclosure.
FIG. 2 is a view illustrating an example of a depth image acquired through an image acquisition unit in practice.
FIG. 3 is view illustrating the hierarchy of a skeleton structure of a human body.
FIG. 4 is a view illustrating a model of a human body represented based on the skeleton structure of FIG. 3.
FIG. 5 is a view illustrating an example of a depth image predicted by a depth image generating unit.
FIG. 6 is a flow chart showing a pose recognition method in accordance with an embodiment of the present disclosure.
FIG. 7 is a view illustrating the configuration of a pose recognition apparatus in accordance with another aspect of the present disclosure.

Reference will now be made in detail to the embodiments of the present disclosure, examples of which are illustrated in the accompanying drawings, wherein like reference numerals refer to like elements throughout.

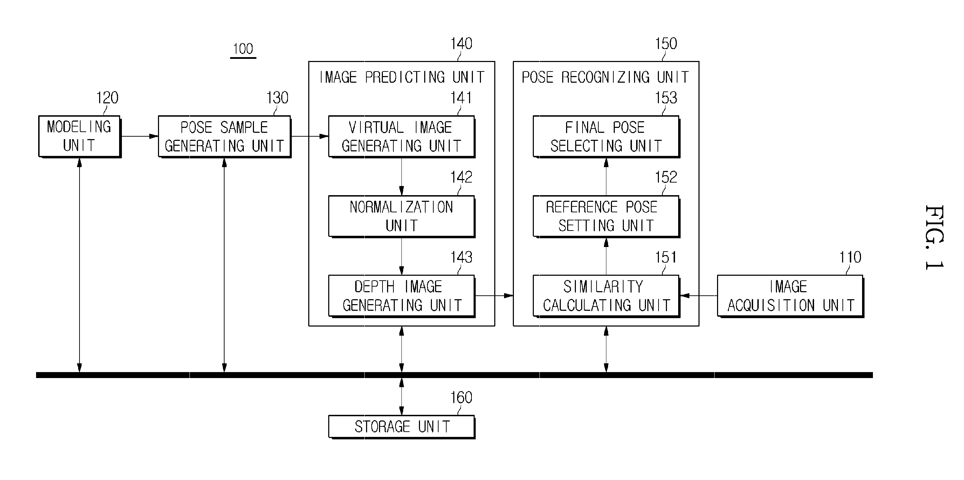

FIG. 1 is a view illustrating the configuration of a pose recognition apparatus 100 in accordance with an embodiment of the present disclosure. Referring to FIG. 1, the pose recognition apparatus 100 may include an image acquisition unit 110, a modeling unit 120, a pose sample generating unit 130, an image predicting unit 140, a pose recognizing unit 150, and a storage unit 160.

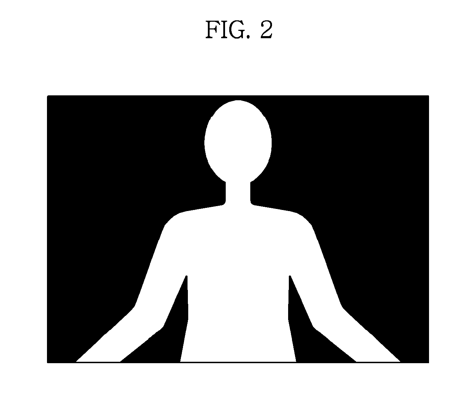

The image acquisition unit 110 includes a prime sensor or a depth camera. The image acquisition unit 110 takes a picture of an object to acquire a depth image about the object. FIG. 2 is a view illustrating an example of a depth image obtained through an image acquisition unit in practice. According to the depth image shown in FIG. 2, a bright portion represents that a distance between the image acquisition unit 110 and the object is small, and a dark portion represents that a distance between the image acquisition unit 110 and the object is large.

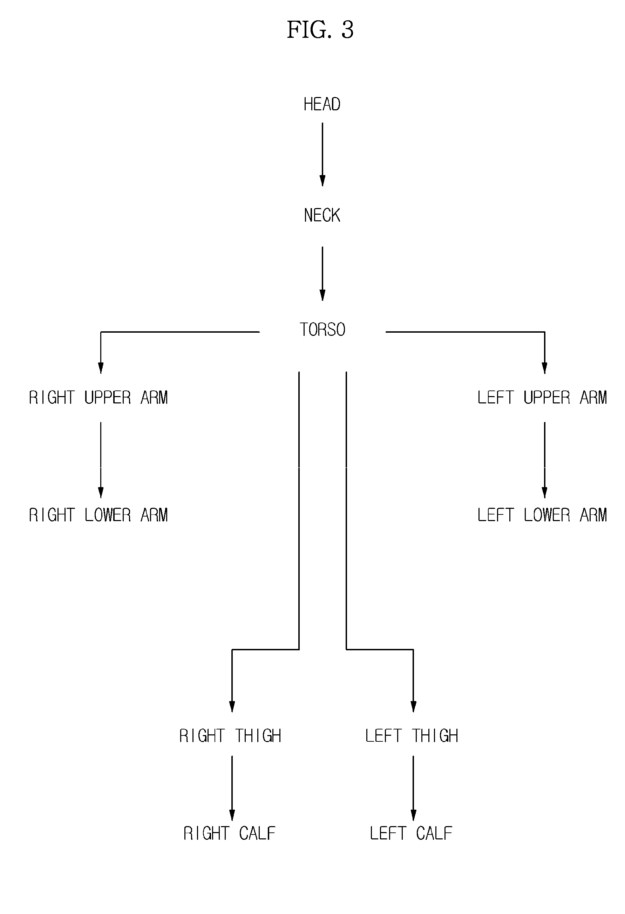

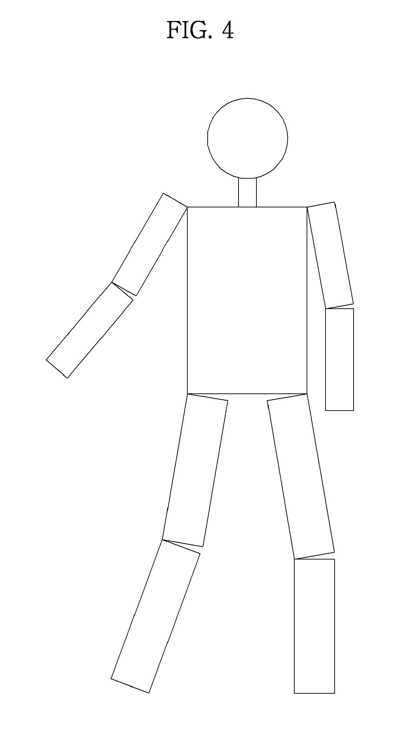

The modeling unit 120 may generate a model of a human body in a virtual space based on a skeleton structure of a human. The skeleton structure of the human has a hierarchy structure shown in FIG. 3. That is, the skeleton structure of the human is composed of a head, a neck, a torso, a left upper arm, a left lower arm, a right upper arm, a right lower arm, a left thigh, a left calf, a right thigh and a right calf. The modeling unit 120, based on the skeleton structure, may generate a model of the human body in a virtual space by representing each part as a cylinder. FIG. 4 is a view illustrating a model of a human body represented based on the skeleton structure of FIG. 3.

The pose sample generating unit 130 may generate a plurality of pose samples by changing an angle (hereinafter, referred to as a joint angle) between each cylinder from an initial pose of the model of the human body.

On FIG. 4, the pose of the model of the human body may be represented as a combination of each joint angle, and each joint angle may be used as a value to copy an actual pose of a human. It may be assumed that the head of the model of the human body has three degrees of freedom of x, y and z and the remaining parts, such as the neck, the torso, the left upper arm, the left lower arm, the right upper arm, the right lower arm, the left thigh, the left calf, the right thigh and the right calf, each have two degrees of freedom of the roll direction and the pitch direction. In this case, a current pose xlimb may be represented as a state vector including state variables, as shown in the following expression 1.

【 Expression 1 】

$$x_{\text{limb}}=[x_{head} \quad y_{head} \quad z_{head} \quad \phi_{neck} \quad \theta_{neck} \quad \phi_{torso} \quad \theta_{torso} \quad \cdots \quad \phi_{leftcalf} \quad \theta_{leftcalf} \quad \phi_{rightcalf} \quad \theta_{rightcalf} \quad ]$$

Herein, xhead represents the x coordinate of the head, yhead represents the y coordinate of the head, and zhead represents the z coordinate of the head. φneck and θneck represent the roll angle of the neck, and the pitch angle of the neck, respectively. φtorso and θtorso represent the roll angle of the torso, and the pitch angle of the torso, respectively. φleftcalf and θleftcalf represent the roll angle of the left calf, and the pitch angle of the left calf, respectively. φright calf and θright calf represent the roll angle of the right calf and the pitch angle of the right calf, respectively.

In order to predict a next pose from the current pose, Markov Chain Mont Carlo (MCMC) may be used. MCMC uses the characteristics of Markov Chain when random variables are simulated. Markov Chain represents a model having random variables being linked in the form of a single chain. As for the Markov Chain, a value of the current random variable is related only to a value of a previous random variable just prior to the current random variable other than values of random variables prior to the previous radon variable. Accordingly, the longer the chain is, the weaker the influence by the initial random variable is. For example, a random variable having a complicated probability distribution may be assumed. In this case, an initial value is given to the random variable, a random variable value is simulated based on the initial value, the simulated value is substituted for an initial value, and another probability distribution value is simulated based on the substituted initial value, thereby leading to the chain becoming stable. Accordingly, a meaningful interpretation may be performed based on values of the chain having a stable state, except for the chain having a unstable state at an initial stage.

When the MCMC is used, the sampling direction may be adjusted such that the sampling is performed in a direction that is the most approximate to a target value. In general, a next pose prediction using the MCMC is as follows. First, a random number δ having a normal distribution is generated. Thereafter, as shown in the following expression 2, a variation δxlimb is generated by adding the random number to one of the state variables that represent the current pose.

【 Expression 2 】

$$\delta x_{\text{limb}} = [\delta x_{head} \quad 0 \quad 0 \quad 0 \quad \cdots \quad 0 \quad 0]$$

Thereafter, the next pose x$_{perturb}$ may be estimated by adding the variation δx$_{limb}$ of the expression 2 to the current pose x$_{limb}$ of the expression 1. That is, if the variation δx$_{limb}$ is added to the current pose x$_{limb}$, the next pose is estimated as shown in the following expression 3.

【 Expression 3 】

$$x_{perturb} = x_{\text{limb}} + \delta x_{\text{limb}}$$

Since such an estimation of the next pose is achieved by changing each joint angle at a small degree from the current pose, the number of pose samples generated is great. In a case that the number of pose samples is great, the amount of computation is increased when a distribution space is set for each joint angle according to each pose sample and a projected simulation is performed.

In order to remove such a constraint, the pose recognition apparatus in accordance with an embodiment of the present disclosure changes the joint angle by applying a velocity. By changing the joint angle with a velocity, the number of pose samples is reduced when compared to the case of sequentially changing the joint angle at a smaller degree.

In order to estimate a velocity component of each joint angle, the pose sample generating unit 130, when forming a state vector for a current pose, may form the state vector having a state variable about a velocity component. The state vector having the state variable about the velocity component added is represented as the following expression 4.

【 Expression 4 】

$$x_{\text{limb}} = [x_{head} \quad y_{head} \quad z_{head} \quad \phi_{neck} \quad \theta_{neck} \quad \phi_{torso} \quad \theta_{torso} \quad \cdots \quad \phi_{leftcalf} \quad \theta_{leftcalf} \quad \phi_{rightcalf} \quad \theta_{rightcalf}$$

$$\dot{x}_{head} \quad \dot{y}_{head} \quad \dot{z}_{head} \quad \dot{\phi}_{neck} \quad \dot{\theta}_{neck} \quad \dot{\phi}_{torso} \quad \dot{\theta}_{torso} \quad \cdots \quad \dot{\phi}_{leftcalf} \quad \dot{\theta}_{leftcalf} \quad \dot{\phi}_{rightcalf} \quad \dot{\theta}_{rightcalf} ]$$

Different from the state vector shown in the expression 1, the state vector shown in the expression 4 is added with velocity components $\dot{x}_{head}$, $\dot{y}_{head}$ and $\dot{z}_{head}$ about the head, and angular velocity components $\dot{\phi}_{neck}$, $\dot{\theta}_{neck}$ ......and $\dot{\phi}_{rightcalf}$, $\dot{\theta}_{rightcalf}$ about the remaining parts. Based on the added components, a velocity component of the next pose may be estimated.

In a state of having the state vector shown in the expression 4, the pose sample generating unit 130 may form a covariance function including covariance values about the respective state variables. The covariance function may be represented as the following expression 5.

【Expression 5】

$$P_{\text{limb}} = [P_{x_{head}x_{head}} \quad P_{x_{head}y_{head}} \quad P_{x_{head}z_{head}} \quad \cdots \quad P_{x_{head}\dot{\phi}_{rightcalf}} \quad P_{x_{head}\dot{\theta}_{rightcalf}}$$
$$\vdots \qquad\qquad\qquad\qquad\qquad \vdots$$
$$P_{\dot{\theta}_{rightcalf}x_{head}} \quad P_{\dot{\theta}_{rightcalf}y_{head}} \quad P_{\dot{\theta}_{rightcalf}z_{head}} \quad \cdots \quad P_{\dot{\theta}_{rightcalf}\dot{\phi}_{rightcalf}} \quad P_{\dot{\theta}_{rightcalf}\dot{\theta}_{rightcalf}}]$$

In the expression 5, $P_{x_{head}y_{head}}$ represents a covariance value with respect to the state variable $x_{head}$ and the state variable $y_{head}$, and $P_{x_{head}z_{head}}$ represents a covariance value with respect to the state variable $x_{head}$ and the state variable $z_{head}$.

When the pose is predicted at first, data about a previous pose does not exist, and thus the covariance value may be set as a random value. Once the pose estimation has been started, the pose sample generating unit 130 may calculate covariance values about the state variables.

If the covariance values are calculated, the pose sample generating unit 130 may generate a variation of the state variables by use of the calculated covariance values. A model for obtaining the variation is set as the following expression 6.

【Expression 6】

$$x_{k+1} = x_k + \dot{x}_k dt$$

In the expression 6, dt represents a time difference to be estimated, and $\dot{x}_k$ represents the angular velocity of $x_k$. If dt is significantly small and a linearity of the angle is ensured, the change in angular velocity becomes the variation. In the expression 6, when assumed that $x_k$ represents a status value of the position estimated at a previous stage and $\dot{x}_k$ represents a status value of the angular velocity of $x_k$, the probability of having the position state value at a next pose as $x_{k+1}$ is highest. Accordingly, if a random variation is generated at $x_{k+1}$, a pose sample having a more similar state to an actual state of a human may be generated.

As described above, the variation may be obtained from the covariance Pn. The covariance Pn represents the multiplication of deviations, and the deviation represents a value of the variable minus the average of the state variables. Accordingly, in order to calculate the covariance, the average is needed to be calculated. The average is obtained through the following expression 7 in a recursive method.

【Expression 7】

$$\bar{x}_n = (x_n / n) + (\bar{x}_{n-1} \cdot (n-1) / n)$$

In the expression 7, the total of n-samples is generated through the MCMC, and the average for the n-samples are obtained by use of the average for the total of n-1 samples.

If the average is obtained through the expression 7, the covariance is calculated. The covariance may be calculated in a recursive method as shown the following expression 8.

【 Expression 8】

$$P_n = \frac{\sum_1^n (x_k - \overline{x}_n)(x_k - \overline{x}_n)^T}{n} = \frac{\sum_1^n (x_k x_k^T - x_k \overline{x}_n^T - \overline{x}_n x_k^T + \overline{x}_n \overline{x}_n^T)}{n}$$

$$\frac{\sum_1^n x_k x_k^T}{n} = V_n = (x_n x_n^T / n) + (V_{n-1} \cdot (n-1) / n)$$

$$P_n = V_n - \overline{x}_n \overline{x}_n^T = (x_n x_n^T / n) + (V_{n-1} \cdot (n-1) / n)$$
$$- ((x_n / n) + (\overline{x}_{n-1} \cdot (n-1) / n))((x_n / n) + (\overline{x}_{n-1} \cdot (n-1) / n))^T$$

In this manner, if the average and the covariance value of the state variables are calculated, the calculated covariance value is used as the size of a normal distribution when generating a random number for generating a variation of the next stage. Accordingly, if a next pose is estimated starting from this stage, the number of pose samples may be reduced. Since the MCMC takes a great of time to reach to a stable state, the present disclosure provides a state, at which the optimum initial condition is satisfied, in the form of a Kalman Filter. Through such, the number of samplings is significantly reduced.

The image predicting unit 140 may predict a depth image about a predicted pose. To this end, the image predicting unit 140 includes a virtual image generating unit 141, a normalization unit 142 and a depth image generating unit 143.

The virtual image generating unit 141 may generate a virtual image of a model of a human body that takes a predetermined pose. The virtual image represents an image predicted about a silhouette of the model of the human body that is to be represented in a captured image when a model of a human body taking a predetermined pose is captured by the image acquisition unit 110. In this case, if the silhouette has a large size, the amount of computation is increased when calculating the depth information about each point in the silhouette. Accordingly, in order to reduce the computation, the size of the virtual image is needed to be reduced. However, if the size of the virtual image is excessively reduced, the size of the silhouette is also reduced, thereby causing a difficulty in distinguishing each part of the silhouette and degrading the pose recognition performance. Accordingly, when the size of the virtual image is reduced, there is a need for reducing the size of the virtual image in consideration of both the amount of computation and the pose recognition performance.

The normalization unit 142 may normalize the size of the virtual image. In this case, the normalization is referred to as transforming the size of the virtual image to a predetermined size. For example, the normalization unit 142 may reduce the size of the virtual image at a predetermined reduction rate. The reduction rate may be determined as the following expression 9.

【 Expression 9】

$$R_{norm} = \frac{l_{size\_of\_image}}{l_{recommended}}$$

In the expression 9, Rnorm represents the reduction rate. lsize_of_image represents the size of a human acquired from the virtual image, and lrecommended represents a desired size for reduction.

A method of reducing the virtual image at the reduction rate determined through the expression 9 is as follows.

【Expression 10】

$$x_{new} = \frac{x_{image}}{R_{norm}}, \; y_{new} = \frac{y_{image}}{R_{norm}}$$

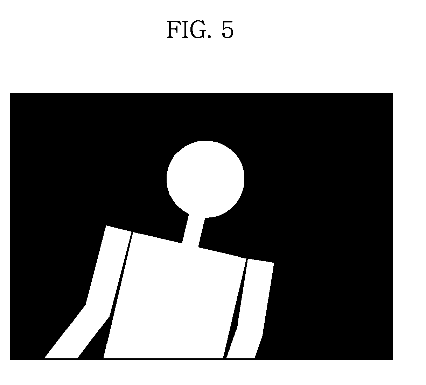

In the expression 10, ximage represents the size in the x-axis of the virtual image, that is, the widthwise size of the virtual image, and xnew represents the size in the x-axis of the reduced virtual image. yimage represents the size in the y-axis of the virtual image, that is, the lengthwise size of the virtual image, and ynew represents the size in the y-axis of the reduced virtual image. As an image is normalized through the expression 10, the amount of the computation is reduced by about $1/R_{norm}^2$ when compared to the case of performing computation on a virtual image that is not subject to the normalization. The depth image generating unit 143 may generate a depth image corresponding to the normalized virtual image. The depth image generated by the depth image generating unit 143 may include depth information about each point existing at an inside the silhouette in the normalized virtual image. FIG. 5 illustrates an example of a depth image predicted by the depth image generating unit 143.

The pose recognition unit 150 may recognize the pose of a human in a depth image being captured in practice by the image acquisition unit 110, based on the similarity between the depth image being generated by the depth image generating unit 143 and the depth image being captured by the image acquisition unit 110. To this end, the pose recognition unit 150 may include a similarity calculating unit 151, a reference pose setting unit 152 and a final pose selecting unit 153.

The similarity calculating unit 151 may calculate the similarity between the depth image being generated by the depth image generating unit 143 and the depth image captured by the image acquisition unit 110. The similarity may be obtained by calculating the difference in depth information between two pixels of corresponding positions at the two depth images, obtaining a result value by summing the calculated differences, and substituting the result value in an inverse exponential function. The similarity may be calculated as the following expression 11.

【Expression 11】

$$W_{img_{diff}} = \exp(-C \sum_{i=1, j=1}^{m,n} (d_{measured}(i, j) - d_{projected}(i, j)))$$

In the expression 11, C is a constant determined through experiments. dmeasured(i,j) represents depth information of a pixel positioned at a ith row and a jth column in a depth image acquired by the image acquisition unit 110. dprojected(i,j) represents depth information of a pixel positioned at a ith row and a jth column in a depth image generated by the depth image generating unit 143. By representing the similarity as an inverse exponential function with respect to a result value, the more similar the two depth images are, the higher value of similarity is represented.

The reference pose setting unit 152 may set a pose having the variation added thereto as a reference pose, according the result of comparing the similarity calculated by the similarity calculating unit 151 with a previously calculated similarity. In detail, if a similarity calculated by the similarity calculating unit 151 is larger than a previously calculated similarity, the reference pose setting unit 152 may set a pose having the variation added thereto as a reference pose. That is, a next pose is predicted by adding the variation to the current pose, a depth image is generated with respect to the predicted pose, the similarity between the generated depth image and the depth image measured in practice is calculated, and if the calculated similarity is higher than a previously calculated similarity, the depth image based on the predicted pose is more similar to a pose of a human captured through the image acquisition unit 110 when compared to a depth image generated based on a previously set pose. Accordingly, if the pose having the variation added thereto is set as a reference pose and a new pose sample is generated based on the reference pose, a pose similar to the actual pose of a human being measured in practice is obtained in a more rapid manner, thereby reducing the number of pose samples to be generated.

If the similarity calculated by the similarity calculating unit 151 is smaller than a similarity previously calculated, the reference pose setting unit 152 may set a previous pose as a reference pose.

The final pose selecting unit 153 may determine whether pose samples having been predicted by the present moment of time are provided in the form of a normal distribution with respect to the pose captured by the image acquisition unit 110.

If determined that the pose samples predicted by the present moment of time are not provided in the form of the normal distribution, the final pose selecting unit 153 informs the pose sample generating unit 130 of the result of determination. Accordingly, the pose sample generating unit 130 may predict a next pose based on the reference pose.

If determined that the pose samples predicted by the present moment of time are provided in the form of the normal distribution, the final pose selecting unit 153 selects a pose sample, which has a highest similarity among similarities based on the pose samples being generated by the present moment of time, as a final pose. After the final pose is selected, the pose of a human in the depth image captured in practice is recognized based on the joint angle of each part from the final pose.

The storage unit 160 may store algorithms or data needed to control the operation of the pose recognition apparatus 100, and data being generated in the course of pose recognition. For example, the storage unit 160 may store the depth image acquired through the image acquisition unit 110, the pose samples generated by the pose sample generating unit 130, and the similarities calculated by the similarity calculating unit 151. Such a storage unit 160 may be implemented as a non-volatile memory device, such as a Read Only Memory (ROM), a Random Access Memory (RAM), a Programmable Read Only Memory (PROM), an Erasable Programmable Read Only Memory (EPROM), and a flash memory; a volatile memory device such as a Random Access Memory (RAM); hard disks; or optical disks. However, the storage unit 160 of the present disclosure is not limited thereto, and may be implemented in various forms generally know in the art.

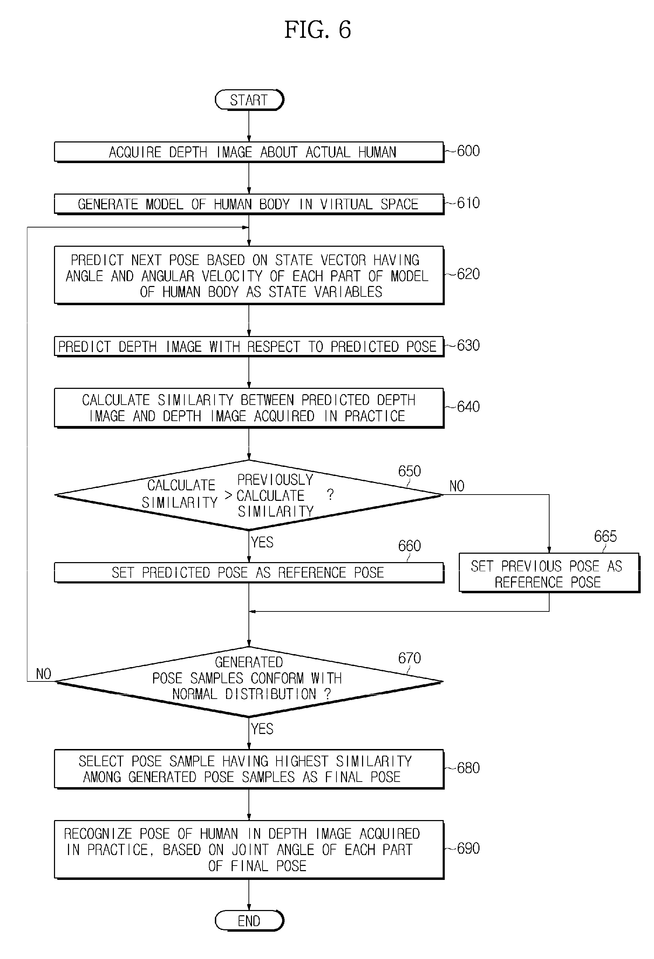

FIG. 6 is a flow chart showing a pose recognition method in accordance with an embodiment of the present.

A depth image about a human through the image acquisition unit 110 is acquired (600).

A model of a human body is generated based on the skeleton structure of the human body in a virtual space (610).

A state vector having an angle and an angular velocity of each part of the model of the human body as state variables is formed, and a next pose of the model of the human body is predicted based on the state vector (620). Operation 620 may include a process of calculating an average and a covariance of the state variables, a process of generating a random number by use of the calculated covariance, and a process of predicting the next pose by use of a variation that is generated based on the random number.

If the next pose of the model of the human body is predicted as the above, a depth image is predicted with respect to the predicted pose (630). Operation 630 may include a process of generating a virtual image with respect to the predicted pose, a process of normalizing the size of the virtual image at a predetermined rate, and a process of generating a depth image with respect to the virtual image having the normalized size. The virtual image represents an image predicted about a silhouette of the model of the human body that is to be represented in an image when the model of the human body takes the predicted pose.

If the depth image is predicted with respect to the predicted pose, the pose of a human in the depth image captured in practice may be recognized based on a similarity between the predicted depth image and a depth image captured by the image acquisition unit 110 in practice.

To this end, first, the similarity between the predicted depth image and the depth image captured in practice may be calculated (640). Thereafter, whether the calculated similarity is higher than a previously calculated similarity is determined (650).

If determined that the calculated similarity is higher than a previously calculated similarity (YES from 650), the predicted pose may be set as a reference pose (660). If determined the calculated similarity is lower than a previously calculated similarity (NO from 650), a previous pose of the model of the human body is set as a reference pose (665).

After the reference pose is set as the above, whether the pose samples having been generated by the present moment of time conform a normal distribution with respect to the pose of a human in the depth image captured in practice is determined (670).

If determined that the pose samples generated by the present moment of time do not conform a normal distribution (NO from 670), the control mode returns to operation 620 to 665 in which the next pose is predicted based on the reference pose, a depth image with respect to the predicted pose, and the similarity between the generated depth image and the depth image captured in practice is compared. If determined that the pose samples generated by the present moment of time conform a normal distribution (YES from 670), a pose sample, which has the highest similarity among similarities based on the pose samples being generated by the present moment of time, is selected as a final pose (680). After the final pose is selected, the pose of a human in the depth image captured in practice is recognized based on the joint angle of each part from the final pose (690).

Although the pose recognition method described with reference to FIG. 6 has been described in relation that operation 600 to acquire the depth image of a human is performed in the beginning of the pose recognition, the present disclosure is not limited thereto. That is, operation 600 may be performed between operation 610 and operation 640.

The pose recognition apparatus and the pose recognition method in an embodiment of the present disclosure have been described as the above.

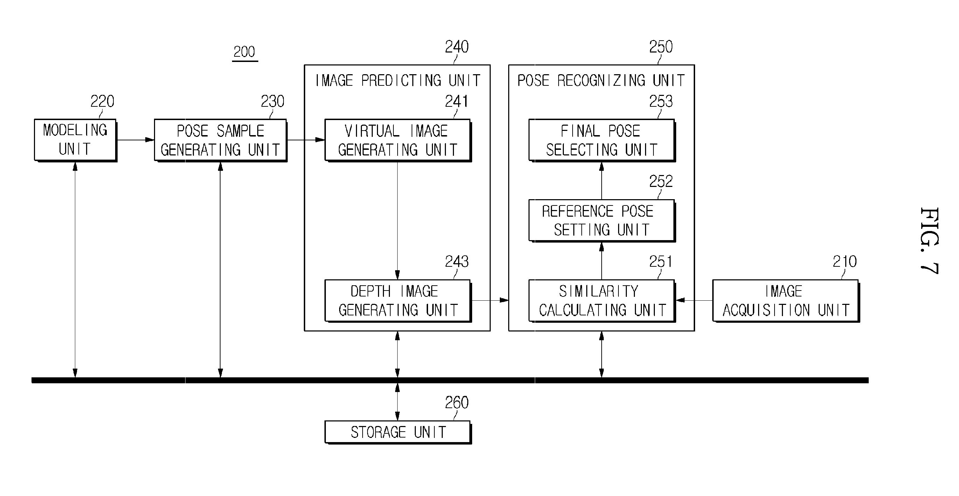

FIG. 7 is a view illustrating the configuration of a pose recognition apparatus in accordance with another aspect of the present disclosure.

Referring to FIG. 7, a pose recognition apparatus 200 may include an image acquisition unit 210, a modeling unit 220, a pose sample generating unit 230, an image predicting unit 240, a pose recognizing unit 250 and a storage unit 260. Since the image acquisition unit 210, the modeling unit 220, the pose sample generating unit 230, the pose recognizing unit 250 and the storage unit 260 are identical to the image acquisition unit 110, the modeling unit 120, the pose sample generating unit 130, the pose recognizing unit 150 and the storage unit 160 shown in FIG. 1, the description thereof will be omitted to avoid redundancy.

The configuration of the pose recognition apparatus 200 shown in FIG. 7 is the same as that of the pose recognition apparatus 100 of FIG. 1 except that the image predicting unit 140 of the pose recognition apparatus 100 of FIG. 1 includes the virtual image generating unit 141, the normalization unit 142 and the depth image generating unit 143 while the image predicting unit 240 of the pose recognition apparatus 200 of FIG. 7 only includes a virtual image generating unit 241 and a depth image generating unit 243. The normalization unit is omitted from the image predicting unit 240 as shown in FIG. 7, but the pose sample generating unit 230 may predict the next pose of the model of the human body based on a state vector having an angle and an angular velocity of each part as state variables and thus the number of the pose samples is reduced and the pose recognition speed is improved.

A pose recognition method applied with the pose recognition apparatus 200 is the same as the control flow shown in FIG. 6 except that the pose recognition method applied with the pose recognition apparatus 100 includes a process of generating a virtual image with respect to the predicted pose, a process of normalizing the size of the virtual image at a predetermined rate, and a process of generating a depth image with respect to the virtual image having the normalized size at operation 630 while the position recognition method applied with the position recognition apparatus 200 only include a process of generating a virtual image with respect to the predicted pose and a process of generating a depth image with respect to the virtual image at operation 630.

As discussed above, embodiments provide a method of recognizing a pose, the method comprising: capturing a depth image of an object; generating a model of the object in a virtual space using at least one processor; predicting a next pose of the model based on a state vector having an angle and an angular velocity of each part of the model as a state variable; predicting a depth image about the predicted pose; and recognizing a pose of the object in the captured depth image, based on a similarity between the predicted depth image and the captured depth image. In some embodiments, the object is a human body.

A few embodiments of the present disclosure have been shown and described. With respect to the embodiments described above, some components composing the pose recognition apparatus 100 in accordance with an embodiment of the present disclosure and the pose recognition apparatus 200 in accordance with another embodiment of the present disclosure can be embodied as a type of 'module'. 'Module' may refer to software components or hardware components such as Field Programmable Gate Array (FPGA) or Application Specific Integrated Circuit (ASIC), and conducts a certain function. However, the module is not limited to software or hardware. The module may be composed as being provided in a storage medium that is available to be addressed, or may be composed to execute one or more processor.

Examples of the module may include an object oriented software components, class components and task components, processes, functions, attributes, procedures, subroutines, segments of a program code, drivers, firm wares, microcode, circuit, data, database, data structures, tables, arrays, and variables. The functions provided by the components and the modules are incorporated into a smaller number of components and modules, or divided among additional components and modules. In addition, the components and modules as such may execute one or more CPU in a device.

The disclosure can also be embodied as computer readable medium including computer readable codes/ commands to control at least one component of the above described embodiments. The medium is any medium that can store and/or transmit the computer readable code.

The computer readable code may be recorded on the medium as well as being transmitted through internet, and examples of the medium include read-only memory (ROM), random-access memory (RAM), CD-ROMs, magnetic tapes, floppy disks, and optical data storage devices. The medium can also be distributed over network coupled computer systems so that the computer readable code is stored and executed in a distributed fashion. In addition, examples of the component to be processed may include a processor or a computer process. The element to be processed may be distributed and/or included in one device.

Although a few embodiments of the present disclosure have been shown and described, it would be appreciated by those skilled in the art that changes may be made in these embodiments without departing from the principles of the disclosure, the scope of which is defined in the claims and their equivalents.

**Claims**

1. A method of recognizing a pose, the method comprising:

   capturing a depth image of an object;
   generating a model of the object in a virtual space using at least one processor;
   predicting a next pose of the model based on a state vector having an angle and an angular velocity of each part of the model as a state variable;
   predicting a depth image about the predicted pose; and
   recognizing a pose of the object in the captured depth image, based on a similarity between the predicted depth image and the captured depth image.

2. The method of claim 1, wherein the object is a human body.

3. The method of claim 1 or 2, wherein the predicting of the next pose of the model comprises:

   calculating an average of the state variable;
   calculating a covariance of the state variable based on the average of the state variable;
   generating a random number based on the covariance of the state variable; and
   predicting the next pose by use of a variation that is generated based on the random number.

4. The method of any one of claims 1 to 3, wherein the predicting of the depth image about the predicted pose comprises:

   generating, if the model of the object takes the predicted pose, a virtual image predicted about a silhouette of the model of the object that is to be represented in an image;
   normalizing a size of the virtual image to a predetermined size; and
   predicting a depth image comprising depth information for each point existing at an inside the silhouette in the normalized virtual image.

5. The method of claim 4 when dependent on claim 1, wherein the normalizing of the size of the virtual image to the predetermined size comprises:

   reducing the size of the virtual image at a predetermined reduction rate,
   wherein the reduction rate is a value of a size of a human, which is acquired in the virtual image, divided by a desired reduction size of the human.

6. The method of any one of claims 1 to 5 when dependent on claim 2, wherein the recognizing of the pose based on the similarity comprises:

   selecting a pose, which has a highest similarity among similarities based on poses having been predicted about the model of the human body by a present moment of time, as a final pose; and
   recognizing the pose of the human in the depth image captured in practice, based on a joint angle of the final pose.

7. The method of claim 6, further comprising:

   calculating a similarity between the predicted depth image and the captured depth image;
   setting, if the calculated similarity is larger than a similarity previously calculated, the predicted pose as a reference pose, and if the calculated similarity is smaller than a similarity previously calculated, setting a previous pose as a reference pose; and
   predicting the next pose based on the reference pose.

8. The method of claim 7, wherein the predicting of the next pose based on the reference pose comprises:

   predicting, if the poses having been predicted about the human body by the present moment of time do not conform a normal distribution with respect to the pose of the human in the depth image captured in practice, a next pose based on the reference pose.

9. A pose recognition apparatus comprising:

an image acquisition unit arranged to capture a depth image of an object;

a modeling unit configured arranged to generate a model of the object in a virtual space;

a pose sample generating unit arranged to predict a next pose of the model based on a state vector having an angle and an angular velocity of each part of the model as a state variable;

an image predicting unit arranged to predict a depth image about the predicted pose; and

a pose recognizing unit arranged to recognize a pose of the object in the depth image captured by the image acquisition unit, based on the similarity between the depth image generated by the depth image generating unit and the depth image captured by the image acquisition unit.

10. The pose recognition apparatus of claim 9, wherein the object is a human body.

11. The pose recognition apparatus of claim 10, wherein the pose sample generating unit is arranged calculate a covariance of the state variable based on an average of the state variable, and predicts the next pose by using a random number, which is generated based on the covariance of the state variable, as a variation.

12. The pose recognition apparatus of claim 11, wherein the image predicting unit comprises:

a virtual image generating unit configured to generate, if the model of the object takes the predicted pose, a virtual image predicted about a silhouette of the model of the object that is to be represented in an image;

a normalization unit configured to normalize a size of the virtual image to a predetermined size; and

a depth image generating unit configured to predict a depth image comprising depth information for each point existing at an inside the silhouette in the normalized virtual image.

13. The pose recognition apparatus of claim 12, wherein the normalization unit is arranged to reduce the size of the virtual image at a predetermined reduction rate.

14. The apparatus of any one of claims 9 to 13 when dependent on claim 10, wherein the pose recognizing unit is arranged to select a pose, which has a highest similarity among similarities based on poses having been predicted about the model of the human body by a present moment of time, as a final pose, and to recognize the pose of the human in the depth image captured in practice, based on a joint angle of the final pose.

15. The pose recognition apparatus of any one of claims 9 to 14, wherein the pose recognizing unit comprises:

a similarity calculating unit to calculate a similarity between the predicted depth image and the captured depth image; and

a reference pose setting unit to, if the calculated similarity is larger than a similarity previously calculated, set the predicted pose as a reference pose, and if the calculated similarity is smaller than a similarity previously calculated, set a previous pose as a reference pose;

optionally wherein the pose sample generating unit, if the poses having been predicted about the human body by the present moment of time do not conform a normal distribution with respect to the pose of the human in the depth image captured in practice, is configured to predict a next pose based on the reference pose.

# FIG. 1

FIG. 2

FIG. 3

HEAD

↓

NECK

↓

TORSO

RIGHT UPPER ARM

↓

RIGHT LOWER ARM

LEFT UPPER ARM

↓

LEFT LOWER ARM

RIGHT THIGH

↓

RIGHT CALF

LEFT THIGH

↓

LEFT CALF

FIG. 4

FIG. 5

# FIG. 6

START

ACQUIRE DEPTH IMAGE ABOUT ACTUAL HUMAN —600

GENERATE MODEL OF HUMAN BODY IN VIRTUAL SPACE —610

PREDICT NEXT POSE BASED ON STATE VECTOR HAVING ANGLE AND ANGULAR VELOCITY OF EACH PART OF MODEL OF HUMAN BODY AS STATE VARIABLES —620

PREDICT DEPTH IMAGE WITH RESPECT TO PREDICTED POSE —630

CALCULATE SIMILARITY BETWEEN PREDICTED DEPTH IMAGE AND DEPTH IMAGE ACQUIRED IN PRACTICE —640

CALCULATE SIMILARITY > PREVIOUSLY CALCULATE SIMILARITY ? 650    NO

YES    660

SET PREDICTED POSE AS REFERENCE POSE

665

SET PREVIOUS POSE AS REFERENCE POSE

NO    GENERATED POSE SAMPLES CONFORM WITH NORMAL DISTRIBUTION ? 670

YES

SELECT POSE SAMPLE HAVING HIGHEST SIMILARITY AMONG GENERATED POSE SAMPLES AS FINAL POSE —680

RECOGNIZE POSE OF HUMAN IN DEPTH IMAGE ACQUIRED IN PRACTICE, BASED ON JOINT ANGLE OF EACH PART OF FINAL POSE —690

END

FIG. 7

**200**